Europäisches Patentamt

European Patent Office

Office européen des brevets

(11) Publication number:

**0 399 527**
**A2**

# (12) EUROPEAN PATENT APPLICATION

(21) Application number: **90109894.7**

(51) Int. Cl.5: **G11C 16/02**

(22) Date of filing: **23.05.90**

(30) Priority: **24.05.89 JP 128715/89**

(43) Date of publication of application:
**28.11.90 Bulletin 90/48**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Hori, Masayuki, 32 E-To**

Toshiba-Daini-Wakakusa-Ryo
4-6, Komukai-Nishimachi, Saiwai-Ku
Kawasaki-Shi, Kanagawa-Ken(JP)
Inventor: **Tozawa, Noriyoshi**
2-1-9-302, Konandai, Konan-Ku
Yokohama-Shi, Kanagawa-Ken(JP)

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Non-volatile semiconductor memory device.**

(57) A non-volatile semiconductor memory device having a plurality of non-volatile memory cells, each cell having a floating gate (6) and control gate (8) above a channel region (1a) sandwiched between a source region (2) and drain region (3) on the surface of a semiconductor substrate (1), and the channel region (1a) on the drain region (3) side facing the floating gate (6) via a thick insulating film (4).

FIG. 1

EP 0 399 527 A2

## FIELD OF THE INVENTION

The present invention relates to a non-volatile semiconductor memory device.

## BACKGROUND OF THE INVENTION

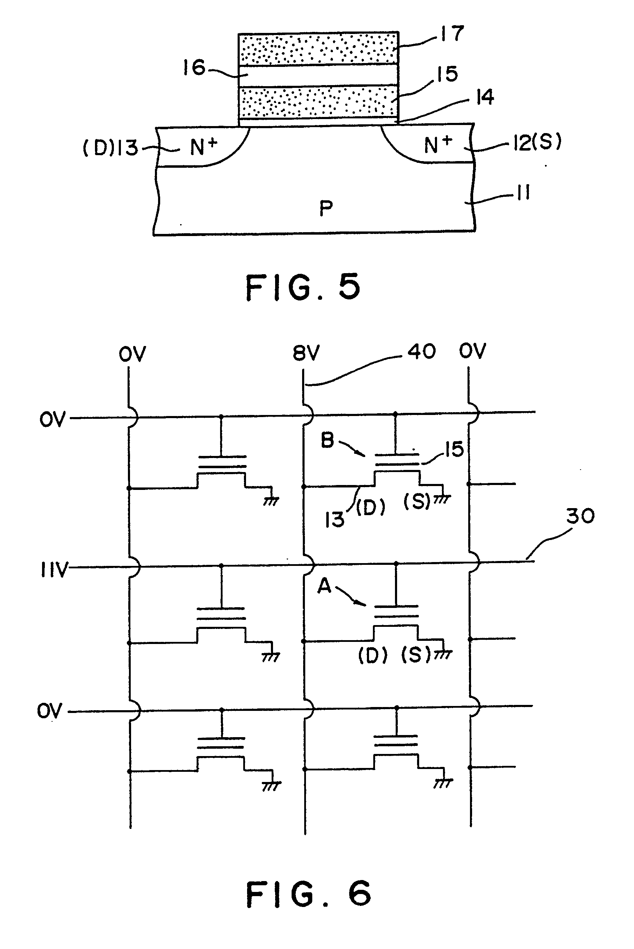

An example of a memory cell of a flash EEPROM according to background art is shown in Fig. 5 in the form of a cross sectional view taken in its channel length direction (L direction).

A source region 12 and drain region 13 are formed on the surface of a semiconductor substrate 11. There is also formed, on the surface of the semiconductor substrate 11 between the source and drain regions 12 and 13, a first thin insulating film 14 having a thickness (e.g., about 100 to 150 Å) sufficient for a tunnel effect to occur. A floating gate 15 is formed on the first insulating film 14. A control gate 17 is formed on the floating gate 15, with a second thick insulating film 16 having a thickness of about 330 Å being interposed therebetween.

The operation principle of the semiconductor memory device described above will be given below.

The operation principle of the semiconductor memory device described above will be given below.

For writing data in this semiconductor memory device, the control gate 17 is applied with about 11 V, the drain region 13 is applied with a high voltage of about 8 V, and the source region 12 is grounded. With this arrangement, hot electrons generated within the substrate 11 are injected into the floating gate 15, to thereby write data in the memory device. For erasing data, the source region is applied with a high voltage of about 10 V. Electrons in the floating gate 15 are thereby removed via the first thin insulating film 14 by means of a tunnel effect, to thus erase the data.

The above-described semiconductor device is, however, associated with the following problem. For writing data, for example, in a cell A shown in Fig. 6, a word line 30 and bit line 40 are selected and high voltage of about 11 V and 8 V are applied thereto, respectively. In this case, the high voltage (8 V) applied to the bit line 40 is also applied, for example, to the drain of a cell B. It is assumed here that data has been already written in the cell B and so electrons have injected into its floating gate 15. In this state, electrons in the floating gate 15 are emitted out due to the electric field generated by the high voltage applied to the drain 13 because the first insulating film 14 is thin. Therefore, there arises a problem of erroneous data erase caused by the undesired emission of electrons from the floating gate 15.

Of the above-described semiconductor memory device, the first insulating film 14 on the semiconductor substrate 11 has a uniform thin film thickness of about 100 Å, so that data written in cells may be erroneously erased while another cell is written.

## SUMMARY OF THE INVENTION

It is an object of the present invention to provide a semiconductor memory device capable of preventing erroneous erase of data already written in cells while another cell is written.

According to a semiconductor memory device of this invention, the insulating film on the channel region is made thick on the drain region side, and made thin on the source region side. It becomes therefore possible to avoid deterioration of the erase characteristic of a memory cell, and prevent erroneous erase of data already written in cells while another cell is written.

## BRIEF DESCRIPTION OF THE DRAWINGS

Fig. 1 is cross sectional view of a cell according to a first embodiment of this invention,

Figs. 2A to 2G are cross sectional views showing manufacturing processes according to the first embodiment,

Fig. 3 is a cross sectional view of a cell according to a second embodiment of this invention,

Figs. 3A, 3B, and 4 are cross sectional views according to fourth, fifth and third embodiments of this invention,

Fig. 5 is a cross sectional view of a cell of a semiconductor memory device according to background art, and

Fig. 6 is a circuit diagram showing data writing to a cell of a semiconductor memory device according to background art.

## DESCRIPTION OF THE PREFERRED EMBODIMENTS

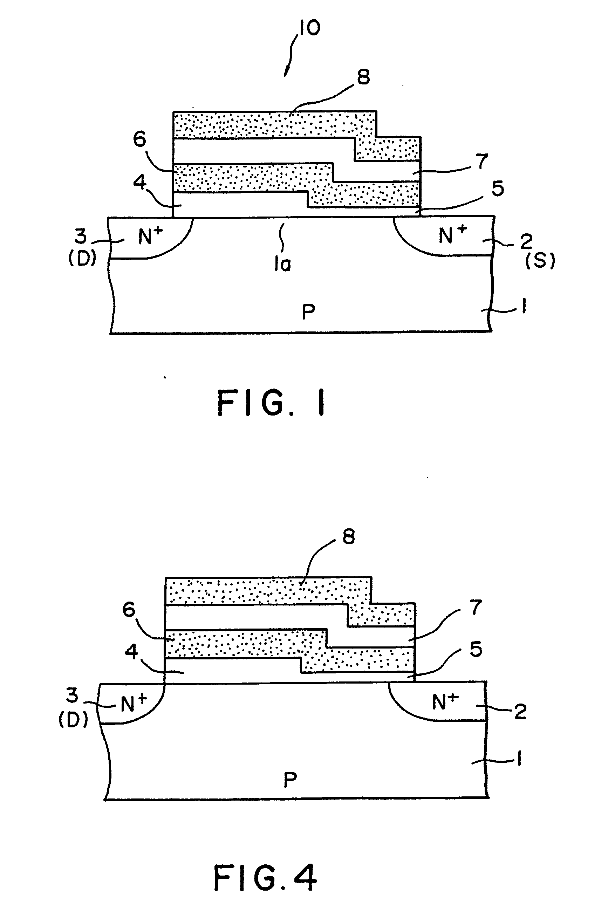

The first embodiment of this invention is shown in Fig. 1. In Fig. 1, there is shown a cross sectional view of a memory cell 10 of a non-volatile semiconductor device taken in a channel length direction (L direction). Reference numeral 1 represents a silicon substrate made of, e.g., P-type silicon (Si). N$^+$-type source region 2 and drain region 3 are formed on the surface of the silicon substrate 1. A first thick oxide film (insulating film) 4 of about 250 to 350 Å is formed on the drain region 3 side of a channel region 1a between the source region 2 and drain region 3. A first thin oxide film (insulating film) 5 is formed on the source region 2 side of the channel region 1a. The thickness of the thin oxide film 5 is set, e.g., to about 100 to 150 Å so as to allow a tunnel current to flow and obtain a good erase characteristic. On the oxide films 4 and 5 there is formed a floating gate 6 made of polysilicon (Poly-Si). On this floating gate 6 there is formed a control gate 8 made of polysilicon with a second oxide film (insulating film) 7 interposed therebetween.

The operation of this embodiment is as follows.

For writing data in a memory cell, for example, with the source region 2 grounded, the control gate 8 is supplied with a voltage of about 11 V and the drain region 3 is supplied with a high voltage of about 8 V. Hot electrons therefore inject into the floating gate 6 for data writing.

For reading data from a memory cell, for example, with the source region 2 grounded, the control gate is supplied with a voltage of about 5 V and the drain region 3 is supplied with a voltage of about 1.5 V. With this arrangements, the data is read from the cell.

For erasing data stored in memory cells, with the control gate 8 grounded, the drain region 3 is grounded or made electrically non-conductive and the source region 2 is supplied with a high voltage of, e.g., about 10 V. With this arrangements, electrons in the floating gate 6 are removed via the first thin oxide film 5 to the source region 2 by means of a tunnel effect.

In the semiconductor memory device, control gates 8 are connected to word lines, and drain regions 3 are connected to bit lines. A desired control gate 8 and drain region 3 are selected by choosing suitable word and bit lines.

In this embodiment, as shown in Fig. 1, the oxide film 4 is made thick on the channel region 1a of the drain region 3 side. Therefore, a tunnel phenomenon is not likely to occur. It is therefore possible to prevent erroneous data erase of cells even while another memory cell is written. In addition, the oxide film 5 is made thin on the channel region 1a of the source region 2 side, so that the erase characteristic of a memory cell is not degraded.

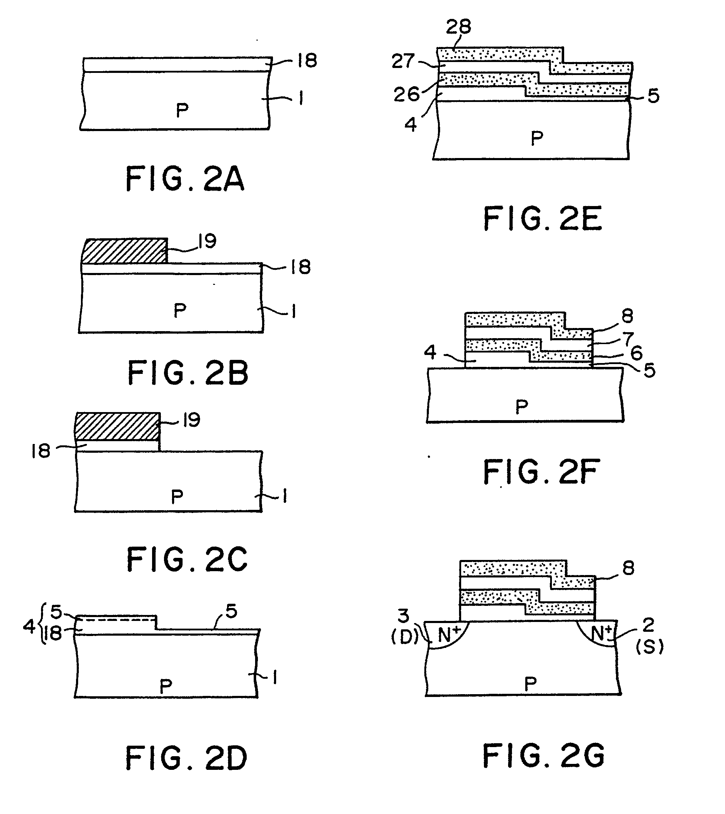

Next, the method of manufacturing a semiconductor memory device according to this embodiment will be described with reference to Figs. 2A to 2G.

As shown in Fig. 2A, an oxide film 18 of about 220 to 250 Å for example is formed on a P-type silicon substrate 1 by means of a thermal oxidation method.

Next, a resist 19 is patterned on the oxide film 18 by means of a Photo Engraving Process (PEP) (Fig. 2B).

Next, for example, the oxide film 18 on the silicon substrate 1 is etched out by using the resist 19 as a mask, by means of a Reactive Ion Etching (RIE) method (Fig. 2C).

Next, after peeling off the resist 19, a thin oxide film 5 of about 100 Å for example is formed over the whole surface of the device, by means of a thermal oxidation method. This thin oxide film 5 deposited on the oxide film 18 makes a thick oxide film 4 (thickness of about 270 Å (Fig. 2D).

Next, a first polysilicon 26 of about 4000 Å for example is deposited on the oxide films 4 and 5, by means of a Chemical Vapor deposition (CVD) method or sputtering method for example. Next, an oxide film 27 of about 330 Å for example is formed on the first polysilicon 26, by means of a thermal oxidation method for example. Next, on the oxide film 27 there is deposited a second polysilicon 28 of about 4000 Å for example, by means of a CVD method or the like (Fig. 2E).

Next, although not shown, after a mask is formed on the second polysilicon 28 by using a PEP resist, a RIE method is used to form a control gate 8 and floating gate 6 in a self alignment manner. Thereafter, the mask (PEP resist) is removed (Fig. 2F).

Next, using as a mask the control gate 8, arsenic (As) ions for example are implanted into the surface of the silicon substrate 1 by means of an ion implantation method to form a source region (diffusion region) 2 and drain region (diffusion region) 3 (Fig. 2G). In the above manner, a cell as shown in Fig. 1 can be obtained.

Use of the above manufacturing method allows to obtain a semiconductor memory device of this embodiment without considerably changing a conventional method of manufacturing a semiconductor memory device.

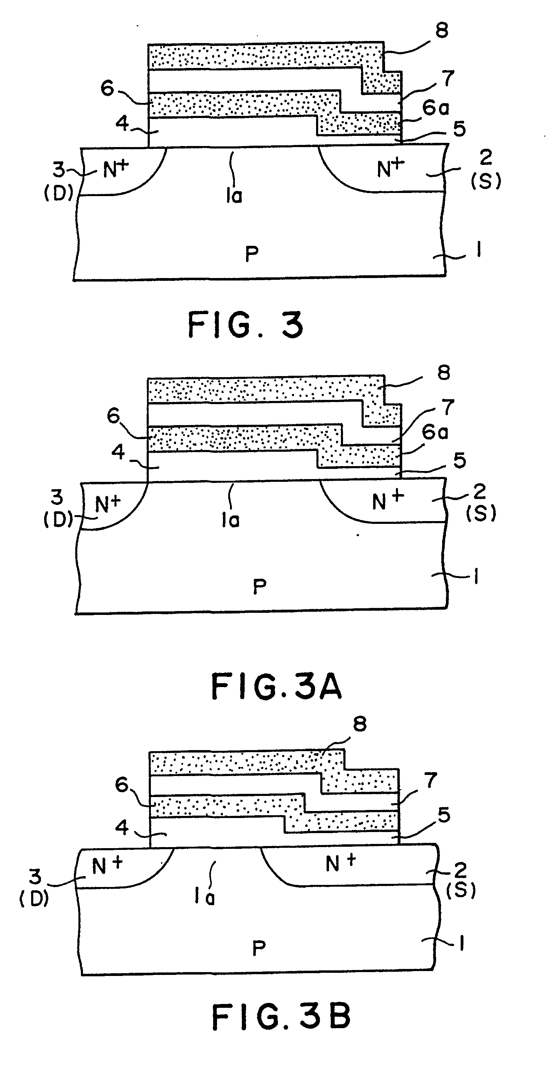

Fig. 3 is a cross sectional view of a cell according to the second embodiment of this invention. The cell shown in Fig. 3 differs from the cell shown in Fig. 1 in that the thick oxide film 4 is formed extending up to the edge of the source region 2. Accordingly, there is a lower possibility of erroneous data erase of cells even while another cell is written.

Fig. 4 is a cross sectional view of a cell according to the third embodiment of this invention. The cell shown in Fig. 4 differs from the cell shown in Fig. 1 in that the drain region 3 does not overlap the floating gate 6. With such an arrangement, there is a lower possibility of erroneous data erase.

This arrangement is also applicable to the embodiment shown in Fig. 3. Namely, as shown in Fig. 3A, the drain region 3 may be formed at the position outside of the floating gate 6.

Fig. 3B shows a fifth embodiment of this invention. A portion of the source region 2 overlaps the floating gate 6 in a direction of thickness while interposing therebetween the thin insulating film 5 and a portion of the thick insulating film 4. With this arrangement, not only erroneous data erase is prevented, but also a leak due to a tunnel between bands is prevented to thereby present advantages of improving an erase characteristic, reducing power consumption, preventing deterioration of a device, and the like.

Like elements to those shown in Fig. 1 are represented by using identical reference numerals in Figs. 3, 3A, 3B and 4.

In the above embodiments, the substrate 1 is of a P-type and the source and drain regions 2 and 3 are of an N-type. The conductivity type of these elements may be reversed.

Reference signs in the claims are intended for better understanding and shall not limit the scope.

## Claims

1. A non-volatile semiconductor memory device comprising:
a plurality of memory cells (10) that data can be electrically written and erased; each of said memory cells comprising:
a semiconductor substrate (1) of a first conductivity type;
a drain region (3) and source region (2) formed on the surface of said semiconductor substrate (1), said drain and source regions being spaced apart by a predetermined distance and of a second conductivity type;
a first insulating film (4, 5) formed on said semiconductor substrate (1) at least on a channel region (1a) between said drain region (3) and source region (2);
a floating gate (6) formed on said first insulating film (4, 5);
a second insulating film (7) formed on said floating gate (6); and
a control gate (8) formed on said second insulating film (7);
wherein said first insulating film (4, 5) includes a thick insulating film (4) on said drain region side and a thin insulating film (5) on said source region side.

2. A non-volatile semiconductor memory device according to claim 1, wherein
said channel region (1a) on said drain region (3) side faces said floating gate (6) via said thick insulating film (4), and
said channel region (1) on said source region (2) side faces said floating gate (6) via said thin insulating film (5).

3. A non-volatile semiconductor memory device according to claim 2, wherein
a portion of said drain region (3) faces said floating gate (6) via said thick insulating film (4), and
a portion of said source region (2) faces said floating gate (6) via said thin insulating film (5).

4. A non-volatile semiconductor memory device according to claim 2, wherein
a portion of said source region (2) faces said floating gate (6) via said thin insulating film (5), and
said drain region (3) is formed on said substrate at the position outside of said floating gate (6) and does not overlap said floating gate (6) in a direction of thickness.

5. A non-volatile semiconductor memory device according to claim 1, wherein
said channel region (1a) faces said floating gate (6) via only said thick insulating film (4), and
said floating gate (6) faces said source region (2) via said thin insulating film (5), but does not overlap said channel region (1a) via said thin insulating film (5) in a direction of thickness.

6. A non-volatile semiconductor memory device according to claim 5, wherein a portion of said drain region (3) faces said floating gate via said thick insulating film (4).

7. A non-volatile semiconductor memory device according to claim 5, wherein said drain region (3) is formed on said substrate at the position outside of said floating gate (6), and said drain region (3) does not overlap said floating gate (6) in a direction of thickness.

8. A non-volatile semiconductor memory device according to claim 5, wherein a portion of said source region (2) overlaps said floating gate (6) via said thin insulating film (5) and a portion of said thick insulating film (4).

9. A non-volatile semiconductor memory device according to claim 1, wherein
data is written by applying a first voltage to said source region (2), a second voltage higher than said first voltage to said drain region (3), and a third voltage higher than said second voltage to said control gate (8);
data is read by applying a fourth voltage to said source region (2), fifth voltage higher than said fourth voltage to said drain region (3), and a sixth voltage higher than said fifth voltage to said control gate (8); and
data is erased by applying a seventh voltage to said control gate (8), and an eighth voltage higher than said seventh voltage to said source region (2).

FIG. 1

FIG. 4

FIG. 2A

FIG. 2B

FIG. 2C

FIG. 2D

FIG. 2E

FIG. 2F

FIG. 2G

FIG. 3

FIG. 3A

FIG. 3B

FIG. 5

FIG. 6